# EUROPEAN PATENT SPECIFICATION

(11) **EP 2 728 990 B1**
(45) Date of publication and mention of the grant of the patent: **12.09.2018**
(21) Application number: 12804210.8
(22) Date of filing: 26.04.2012
(51) Int. Cl.: H05K 13/04, H05K 13/02

(54) **ELECTRONIC CIRCUIT COMPONENT MOUNTING SYSTEM**
KOMPONENTENMONTAGESYSTEM FÜR ELEKTRONISCHE SCHALTUNGEN
SYSTÈME DE MONTAGE DE COMPOSANT DE CIRCUIT ÉLECTRONIQUE

(30) Priority: 28.06.2011 JP 2011143034
(43) Date of publication of application: 07.05.2014
(73) Proprietor: Fuji Machine Mfg. Co., Ltd., Chiryu-shi Aichi 472-8686 (JP)
(72) Inventor: IISAKA, Jun, Chiryu-shi Aichi 472-8686 (JP)
(74) Representative: Grünecker Patent- und Rechtsanwälte PartG mbB
(86) International application number: PCT/JP2012/061253
(87) International publication number: WO 2013/001904

(56) References cited:
- JP-A- 2007 210 650
- JP-A- 2009 152 252
- JP-A- 2011 100 787
- US-A1- 2002 054 813
- US-B1- 6 176 007

## Description

### TECHNICAL FIELD

The present invention relates to an electronic-circuit-component mounting system configured to take an electronic circuit component from a component holder such as a tray and mount the electronic circuit component onto a circuit substrate and in particular to a technique capable of providing a smaller component holder that can hold the same number of electronic circuit components.

### BACKGROUND ART

In a conventional tray for supplying electronic circuit components, as described in the following patent document 1, each of a plurality of component accommodation recessed portions arranged in a plane accommodates one electronic circuit component.

### PRIOR ART DOCUMENTS

### PATENT DOCUMENTS

Patent Document 1: JP-A-2008-10594, Patent document 2: US 6 176 007 B1

### SUMMARY OF THE INVENTION

### PROBLEM TO BE SOLVED BY THE INVENTION

However, there is room for improvements in the conventional tray. For example, since a plurality of component accommodation recessed portions arranged in a grid pattern at predetermined pitches in a line direction and a column direction respectively accommodate electronic circuit components in the same rotational phase, only a smaller number of component accommodation recessed portions can be formed in one tray in a case where each electronic circuit component has a planar shape such as an L-shape which is hard to arrange in high density. As a result, a plurality of trays may be required to supply the same number of electronic circuit components, or alternatively a larger tray and accordingly a larger space therefor may be required to supply a desired number of electronic circuit components from one tray. Thus, there is room for improvements.

This invention has been developed in view of the above-described situations, and it is an object of the present invention to provide an electronic-circuit-component mounting system capable of mounting electronic circuit components supplied from an improved component holder.

### MEANS FOR SOLVING PROBLEM

The above-described problem is solved by an electronic-circuit-component mounting system including (a) a component holder support device configured to support a component holder which includes a plurality of unit spaces defined according to repetition of a first rule and which holds a plurality of electronic circuit components in each of the plurality of unit spaces in a plurality of states defined according to a second rule, (b) a circuit substrate support device configured to support a circuit substrate on which an electronic circuit component is to be mounted, (c) a component holding member configured to releasably hold the electronic circuit component, (d) a component holding position obtainer configured to sequentially obtain a plurality of component holding positions each of which is a component holding position at which the component holding member is to hold a corresponding one of the plurality of electronic circuit components held in the plurality of unit spaces of the component holder supported by the component holder support device, (e) a component mounting position obtainer configured to sequentially obtain a plurality of component mounting positions each of which is a component mounting position at which a corresponding one of the plurality of electronic circuit components is to be mounted on the circuit substrate supported by the circuit substrate support device, and (f) a relatively moving device configured to move the component holder support device and the circuit substrate support device, and the component holding member relatively to each other based on the component holding position obtained by the component holding position obtainer and the component mounting position obtained by the component mounting position obtainer, and thereafter control the component holding member to take the electronic circuit component from the component holder supported by the component holder support device, hold the electronic circuit component, and mount the electronic circuit component onto the circuit substrate supported by the circuit substrate support device.

The problem is solved more satisfactorily by designing at least one of the component holding position obtainer and the component mounting position obtainer to obtain at least one of: a rotational position of the component holding member at the time when the electronic circuit component is taken from the component holder; and a rotational position of the component holding member at the time when the electronic circuit component is mounted on the circuit substrate.

### EFFECT OF THE INVENTION

In the electronic-circuit-component mounting system having the above-described construction, the electronic circuit component can be taken from the component holder which includes the plurality of unit spaces defined according to repetition of the first rule and which holds the plurality of electronic circuit components in each of the plurality of unit spaces in the plurality of states defined according to the second rule, and then the electronic circuit component can be mounted on the circuit substrate. In the above-described component holder, density of arrangement of electronic circuit components can be made high when compared with the conventional component holder, thereby reducing frequency of replacement of the component holder, resulting in reduction in man-hour accordingly. Also, consumption of the component holders can be reduced.

### FORMS OF THE INVENTION

There will be described by way of examples forms of inventions recognized to be claimable by the present applicant. The inventions may be hereinafter referred to as "claimable inventions", and include the invention as defined in the appended claims (which may be referred to as "the invention" or "the invention of the present application"), an invention of a concept subordinate or superordinate to the concept of the invention of the present application, and/or an invention of a concept different from the concept of the invention of the present application. The forms are numbered like the appended claims and depend on another form or forms, where appropriate. This is for easier understanding of the claimable invention, and it is to be understood that combinations of constituent elements that constitute the claimable inventions are not limited to those of the following forms. That is, the claimable inventions are to be construed by taking account of the description following each form, the description of the embodiments, the related art, the common general technical knowledge, and others, and as long as the claimable inventions are constructed in this way, any form in which one or more elements are added to or deleted from any one of the following forms may be considered as one form of the claimable invention.

In the following forms, the form (1) corresponds to claim 1, the form (2) to claim 2, the form (3) to claim 3, the form (4) to claim 4, and the form (5) to claim 5.
(1) An electronic-circuit-component mounting system, comprising:
   a component holder support device configured to support a component holder which comprises a plurality of unit spaces defined according to repetition of a first rule and which holds a plurality of electronic circuit components in each of the plurality of unit spaces, each of the unit spaces being configured as component accommodation recessed portion and/or being configured to gold a plurality of components having different rotation orientations, the electronic circuit components being arranged in the same pattern in each of the unit spaces, this pattern being defined according to a second rule;
   a circuit substrate support device configured to support a circuit substrate on which an electronic circuit component is to be mounted;
   a component holding member configured to releasably hold the electronic circuit component;
   a component holding position obtainer configured to sequentially obtain a plurality of component holding positions each of which is a component holding position at which the component holding member is to hold a corresponding one of the plurality of electronic circuit components held in the plurality of unit spaces of the component holder supported by the component holder support device;
   a component mounting position obtainer configured to sequentially obtain a plurality of component mounting positions each of which is a component mounting position at which a corresponding one of the plurality of electronic circuit components is to be mounted on the circuit substrate supported by the circuit substrate support device; and
   a relatively moving device configured to move the component holder support device and the circuit substrate support device, and the component holding member relatively to each other based on the component holding position obtained by the component holding position obtainer and the component mounting position obtained by the component mounting position obtainer, and thereafter control the component holding member to take the electronic circuit component from the component holder supported by the component holder support device, hold the electronic circuit component, and mount the electronic circuit component onto the circuit substrate supported by the circuit substrate support device.

   While it is effective in particular to implement the present invention in the mode described in the next form, the present invention is not limited to this mode. It is possible to make a density of arrangement of the electronic circuit components higher than that in the conventional system by arranging the plurality of electronic circuit components in each of the plurality of unit spaces defined according to repetition of the first rule and in one of the plurality of states defined according to the second rule. For example, a flat tray is commonly constructed such that stiffening ribs are formed in a grid pattern on the tray, and recesses are formed respectively between the stiffening ribs and used as component accommodation recessed portions in order to improve stiffness of the tray. In this construction, pitches of the component accommodation recessed portions and pitches of the stiffening ribs are inevitably the same as each other. Since the thickness of each stiffening rib has to be some degree of thickness because of a technique of forming a component holder, a density of arrangement of the component accommodation recessed portions lowers accordingly. However, by forming a plurality of accommodation recessed portions in a space between the stiffening ribs adjacent to each other, it is possible to improve a density of formation of the component accommodation recessed portions, i.e., a density of arrangement of the electronic circuit components as specifically explained later in the explanation of embodiments.
(2) The electronic-circuit-component mounting system according to the above form (1), wherein at least one of the component holding position obtainer and the component mounting position obtainer is configured to further obtain at least one of: a rotational position of the component holding member at a time when the electronic circuit component is taken from the component holder; and a rotational position of the component holding member at a time when the electronic circuit component is mounted on the circuit substrate.
   In the electronic-circuit-component mounting system described in the present form, in a case where the component holder holds the electronic circuit components in a state in which electronic circuit components respectively in different rotational phases are held in a unit space, the component holding member can take the electronic circuit component from the component holder and mount the electronic circuit component onto the circuit substrate. Thus, the electronic circuit components having a shape such as an L-shape in plan view which are hard to arrange densely in the component holder in a case where a rotational phase of each electronic circuit component is limited to one phase can be arranged densely as specifically explained later as an embodiment, making the system more effective.
(3) The electronic-circuit-component mounting system according to the above form (1) or (2), wherein the component holder support device comprises a surface holder support device configured to support a surface holder as the component holder which comprises the plurality of unit spaces arranged according to a rule defined repeatedly in two directions which intersect each other on one surface of the surface holder.
   One example of the surface holder is a tray whose one surface is a flat surface, but the surface holder may be a flexible sheet. In the latter case, the component holder support device may be configured to hold the surface holder in a state in which the sheet is bent, for example, in a state in which the sheet is wrapped around a surface of a cylinder, with a surface of the sheet for holding the electronic circuit component facing outward in a radial direction or in a state in which the sheet is rolled (noted that the surface of the sheet for holding the component may face outward or inward), so that a space required for installing the component holder support device can be made smaller, and a distance of relative movement caused by the relatively moving device can be made shorter, resulting in improvement in efficiency of the mounting operation. In the latter case, however, it is preferable to provide a means for preventing the electronic circuit components from dropping off the component holder, such as the cover, a means for sucking the electronic circuit components toward the sheet, and a means for bonding the electronic circuit components to the sheet.
(4) The electronic-circuit-component mounting system according to the above form (3), wherein an order of the plurality of unit spaces is determined in advance, wherein a processing is repeatedly executed for the plurality of unit spaces in the order of the plurality of unit spaces, wherein, in the processing, the relatively moving device causes the component holding member to hold one by one a plurality of electronic circuit components held by an earlier unit space to which an earlier order number is assigned among the plurality of unit spaces, and after all of the plurality of electronic circuit components held by the earlier unit space are held, the relatively moving device causes the component holding member to hold one by one all of a plurality of electronic circuit components held by a later unit space in the same order as an order in which the component holding member holds the plurality of electronic circuit components held by the earlier unit space, and wherein the later unit space is a space to which an order number that follows the order number of the earlier unit space is assigned,.
(5) The electronic-circuit-component mounting system according to the above form (3), wherein an order of the plurality of unit spaces is determined in advance, wherein a processing is repeatedly executed for the plurality of unit spaces in the order of the plurality of unit spaces, and wherein, in the processing, the relatively moving device causes the component holding member to hold one electronic circuit component held in a first state of the plurality of states in an earlier unit space to which an earlier order number is assigned among the plurality of unit spaces, and next the relatively moving device causes the component holding member to hold an electronic circuit component held in the first state in a later unit space to which an order number that follows the order number of the earlier unit space is assigned.
(6) The electronic-circuit-component mounting system according to the above form (4) or (5), wherein the plurality of unit spaces are defined as a unit space group comprising a predetermined number of unit spaces in the order of the plurality of unit spaces, and the relatively moving device is configured to repeatedly execute the processing in the unit space group.
(7) The electronic-circuit-component mounting system according to the above form (6), wherein the relatively moving device is configured to operate by considering the unit spaces of the entire component holder as the unit space group.

### BRIEF DESCRIPTION OF THE DRAWINGS

Fig. 1 is a plan view illustrating an electronic-circuit-component mounting system as one embodiment.
Fig. 2 is a side view illustrating a mounting head of a mounting controller of the electronic-circuit-component mounting system.
Fig. 3 is a plan view illustrating a tray-type component supply device of the electronic-circuit-component mounting system.
Fig. 4 is a side view illustrating the tray-type component supply device seen from the right side.
Fig. 5 is a plan view illustrating trays and a support table of the tray-type component supply device.
Fig. 6 is a plan view illustrating one example of a conventional tray.
Fig. 7 is a plan view illustrating another example of the conventional tray.
Fig. 8 is a plan view illustrating in enlargement a portion of the tray illustrated in Fig. 5.
Fig. 9 is a cross-sectional view taken along line 9-9 in Fig. 8.
Fig. 10 is a plan view illustrating in enlargement a portion of a tray that differs from the tray illustrated in Fig. 5.
Fig. 11 is a cross-sectional view taken along line 11-11 in Fig. 10.
Fig. 12 is a block diagram illustrating a control device of the electronic-circuit-component mounting system.
Fig. 13 is a flow chart illustrating a tray-data creating program stored in a ROM of the control device.
Fig. 14 is a flow chart illustrating a mounting program stored in the ROM of the control device.
Fig. 15 is a flow chart illustrating a processing of taking components from the multi-component arranged tray in a component taking step of the mounting program.
Fig. 16 is a view for explaining the order in which components are taken from the multi-component arranged tray.
Fig. 17 is another view for explaining the order in which the components are taken from the multi-component arranged tray.
Fig. 18 is a schematic view for explaining an orientation of the multi-component arranged tray on the tray support table.
Fig. 19 is a plan view illustrating a multi-component arranged tray held by a tray-type component supply device of a electronic-circuit-component mounting system according to another embodiment of the claimable invention.
Fig. 20 is a cross-sectional view taken along line 20-20 in Fig. 19.
Fig. 21 is a table as one example of a taking data table that is created upon execution of the tray-data creating program illustrated in the flow chart in Fig. 13.
Fig. 22 is a table as another example of the taking data table that is created upon execution of the tray-data creating program illustrated in the flow chart in Fig. 13.

### EMBODIMENTS OF THE INVENTION

Hereinafter, there will be described embodiments of the claimable invention by reference to the above-described drawings.

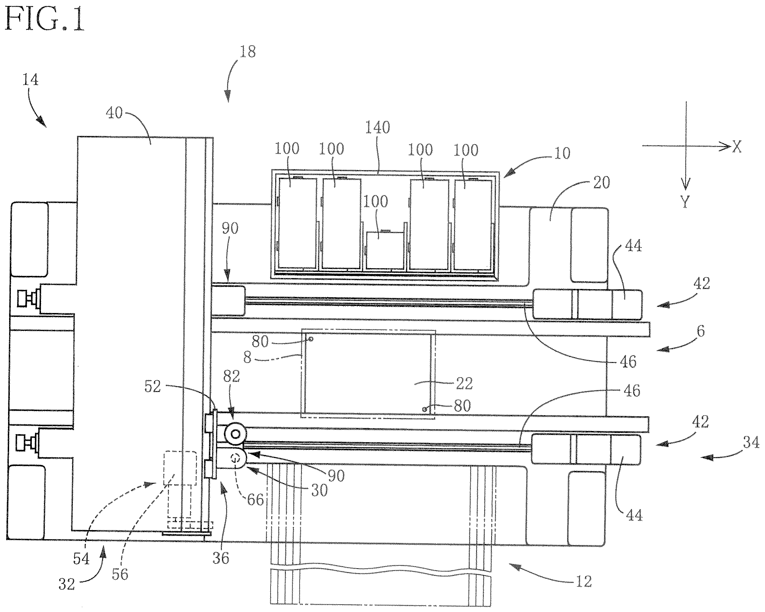

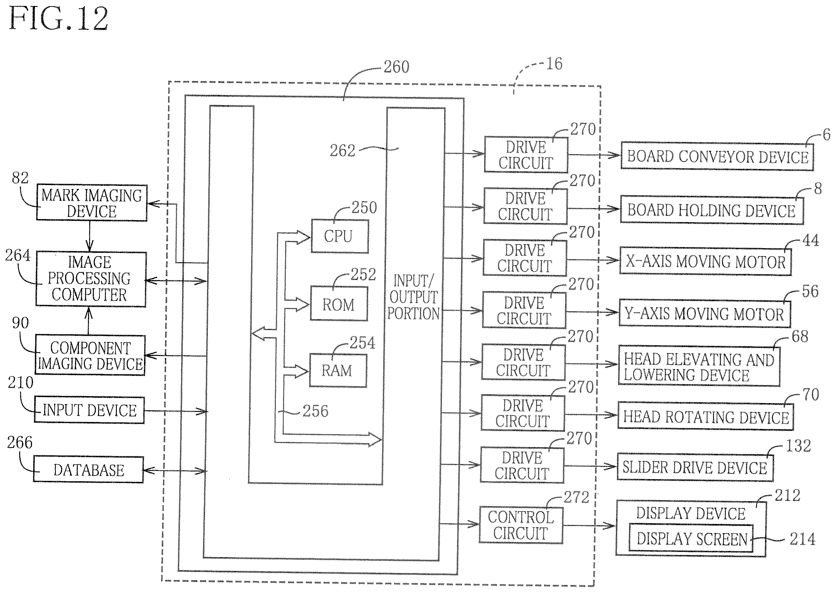

Fig. 1 illustrates an electronic-circuit-component mounting system according to one embodiment of the claimable invention. The present electronic-circuit-component mounting system includes at least one electronic-circuit-component mounting machine 18 each including: a board conveyor device 6; a board holding device 8; a tray-type component supply device 10; a feeder-type component supply device 12; a mounting device 14; and a control device 16 (see Fig. 12). The board conveyor device 6 is provided on a bed 20 as a mounting-machine main body and configured to convey a circuit board 22 as one kind of a circuit substrate in one direction such that the circuit board 22 maintains a horizontal attitude. The board holding device 8 includes a support member and a clamp member, for example. The support member supports a lower side of the circuit board 22 loaded by the board conveyor device 6 and stopped by the board holding device 8, and the clamp member clamps opposite sides of the circuit board 22 which extend parallel to a conveying direction. The circuit board 22 is supported with its component mount surface being horizontal.

As illustrated in Fig. 1, the mounting device 14 includes a head unit 30 and a head moving device 32. The head moving device 32 moves the head unit 30 in two directions perpendicular to each other, in a plane parallel to the component mount surface of the circuit board 22 held by the board holding device 8. One of the two directions is an X-axis direction, and the other is a Y-axis direction. In the present electronic-circuit-component mounting system, a direction parallel to the substrate conveying direction is the X-axis direction, and each of the X-axis direction and the Y-axis direction is horizontal. The head moving device 32 includes an X-axis-direction moving device 34 and a Y-axis-direction moving device 36 and moves the head unit 30 to any position in a horizontal plane.

As illustrated in Fig. 1, the X-axis-direction moving device 34 includes: an X-axis slide 40 as a movable member; and a pair of X-axis-slide moving devices 42. Each of the X-axis-slide moving devices 42 includes: an X-axis moving motor 44 as a drive source; a ball screw 46 as a feed screw; and a nut, not shown. The X-axis-slide moving devices 42 moves the X-axis slide 40 to any position in the X-axis direction. The Y-axis-direction moving device 36 is provided on the X-axis slide 40 and includes: a Y-axis slide 52 as a movable member; and a Y-axis-slide moving device 54. The Y-axis-slide moving device 54 includes: a Y-axis moving motor 56 as a drive source; a ball screw; and a nut, not shown, and moves the Y-axis slide 52 to any position in the Y-axis direction. Each of the motors 44, 56 is one kind of an electric motor and constituted by a servomotor with an encoder as one kind of an electric rotary motor which allows accurate control of its rotation angle, for example.

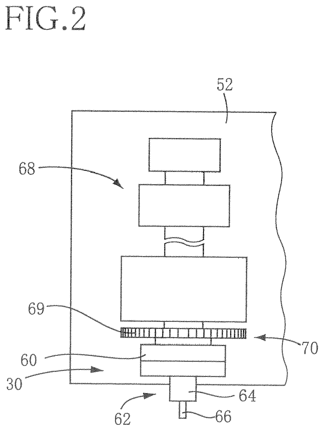

In the present electronic-circuit-component mounting system, as illustrated in Fig. 2, the head unit 30 is provided on the Y-axis slide 52. The head unit 30 includes a head holding device 60 and mounting heads 62. These head holding device 60 and each mounting head 62 have construction similar to those of a head holding device and a mounting head described in JP-A-6-291490. The head holding device 60 removably holds the mounting head 62 by a negative pressure supplied from a negative pressure source. The head unit 30 is elevated and lowered by a head elevating and lowering device 68 provided in the Y-axis slide 52. Also, the head unit 30 is rotated about its vertical axis by a gear 69 and a head rotating device 70 that includes: another gear (not shown) engaged with the gear 69; and an electric motor (not shown) for rotating the gears.

The mounting head 62 includes a nozzle holding portion 64 and a vacuum nozzle 66 as a component holding member held by the nozzle holding portion 64. The vacuum nozzle 66 sucks and holds an electronic circuit component using a negative pressure. A switching device, not shown, (constituted by an electromagnetic open/close valve as one kind of an electromagnetic control valve, for example) selectively permits and inhibits supply of the negative pressure to the vacuum nozzle 66. The head holding device 60 selectively holds one of the mounting heads 62 of a plurality of types that differ from each other in at least one of a diameter of a suction pipe of the vacuum nozzle 66 and the number of the nozzle holding portions 64.

As illustrated in Fig. 1, the Y-axis slide 52 is provided with a mark imaging device 82 as an imaging device configured to take images of a plurality of fiducial marks 80 provided on the circuit board 22. This mark imaging device 82 is moved by the head moving device 32 to any position in a horizontal plane. The head moving device 32 is a component-holding-member moving device and is also an imaging-device moving device. The mark imaging device 82 is constituted by a CCD camera as an imaging device, for example, but may be constituted by a CMOS camera. The X-axis slide 40 is provided with two pairs of component imaging devices 90 each for taking an image of the electronic circuit component sucked by the vacuum nozzle 66, and these component imaging devices 90 take images of the electronic circuit components supplied by the tray-type component supply device 10 and the feeder-type component supply device 12. The mounting device 14 may be configured such that the X-axis slide is provided on the Y-axis slide, and the mounting head is provided on the X-axis slide.

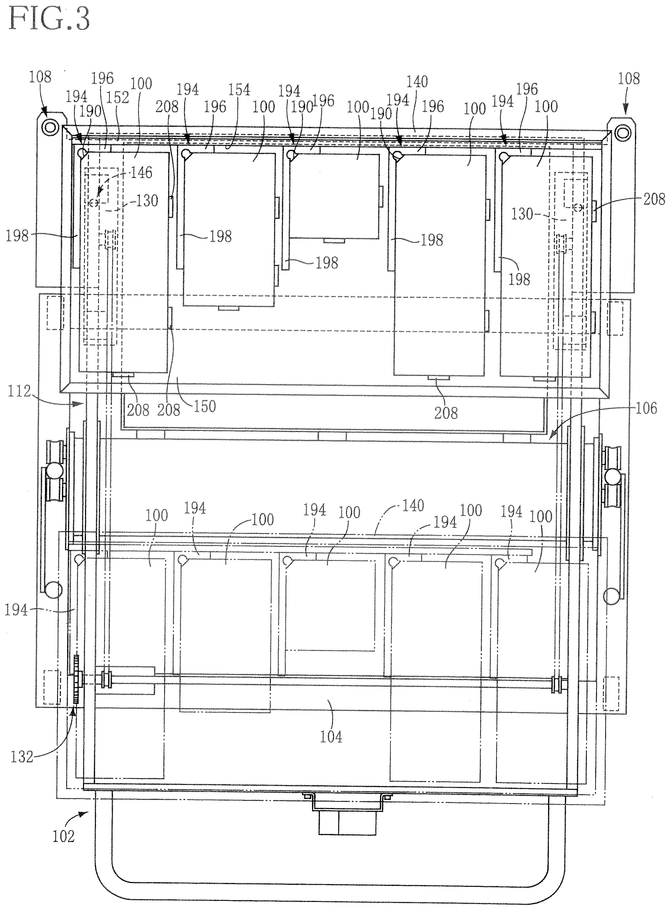

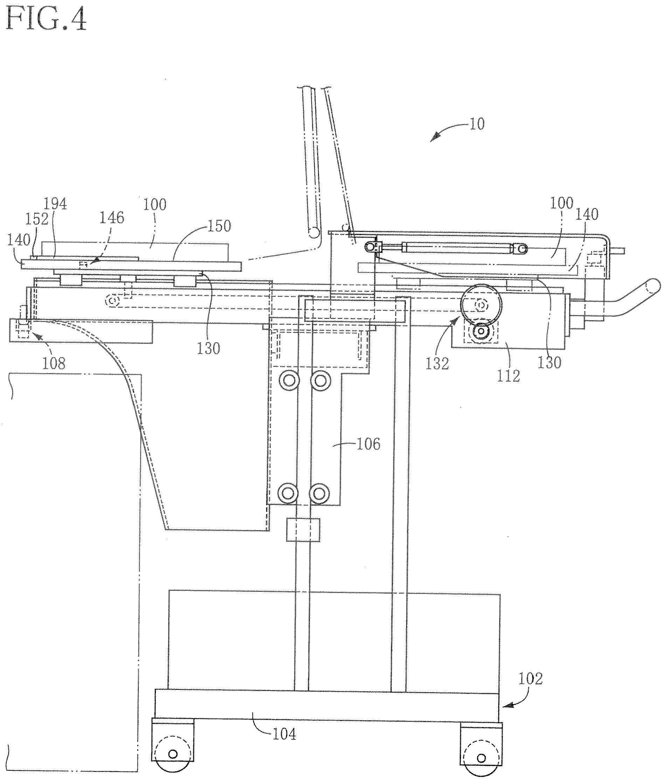

There will be next explained the tray-type component supply device 10. As illustrated in Figs. 3 and 4, the tray-type component supply device 10 is configured to accommodate electronic circuit components on trays 100 and supply the electronic circuit components. The present tray-type component supply device 10 has the same construction as a tray-type component supply device described in JP-A-2007-201416 other than portions relating to the claimable invention and will be explained simply.

The tray-type component supply device 10 includes a wheeled table 102 as a main body of the supply device and can be connected to and separated from the mounting device 14. The wheeled table 102 includes a vehicle body 104 and an elevating and lowering member 106 provided on the vehicle body 104 movably in an up and down direction. This elevating and lowering member 106 is positioned by a positioning device 108, and thereby the wheeled table 102 is positioned in a horizontal direction and connected to the mounting device 14. In the connected state, the widthwise direction and the right and left direction of the tray-type component supply device 10 are parallel to the X-axis direction, and the front and rear direction thereof is parallel to the Y-axis direction. In the front and rear direction, a side of the tray-type component supply device 10 nearer to the board holding device 8 is a front side, and a side thereof farther from the board holding device 8 is a rear side.

The trays 100 are supported on a support portion 112 that is provided on the elevating and lowering member 106. Located at an upper position, the elevating and lowering member 106 is connected to the mounting device 14. In this state, the height of an upper face of an L-shaped ruler (which will be described below) for positioning the tray 100 becomes generally equal to that of the component mount surface as an upper face of the circuit board 22 held by the board holding device 8, allowing the mark imaging device 82 to take images of marks in a state in which focus is achieved for each of the circuit board 22 and the L-shaped ruler. The mark imaging device 82 may be provided so as to be elevated and lowered by an elevating and lowering device such that focus is achieved for each mark. Also, the mark imaging device 82 may be a camera whose focal length is adjustable. As illustrated in Fig. 4, the support portion 112 is provided on the elevating and lowering member 106 in a state in which the support portion 112 extends in the front and rear direction. A pair of sliders 130 as a movable member is provided movably in the front and rear direction and moved by a slider drive device 132.

The trays 100 are supported by a tray support table (hereinafter abbreviated as "support table") 140 and thereby mounted on the wheeled table 102. This support table 140 is shaped like one plate and removably supported on the pair of sliders 130 in a state in which the support table 140 is positioned in the horizontal direction with respect to the pair of sliders 130 by a support-table positioning device 146, whereby the support table 140 is positioned with respect to the mounting device 14. The movement of the sliders 130 moves the support table 140 to: a supply position illustrated in solid lines in Fig. 4 at which the support table 140 is located nearer to the mounting device 14, and the electronic circuit components are supplied from the trays 100; and a distant position illustrated in two-dot chain lines at which the support table 140 is located farther from the mounting device 14 and at a rear of the supply position.

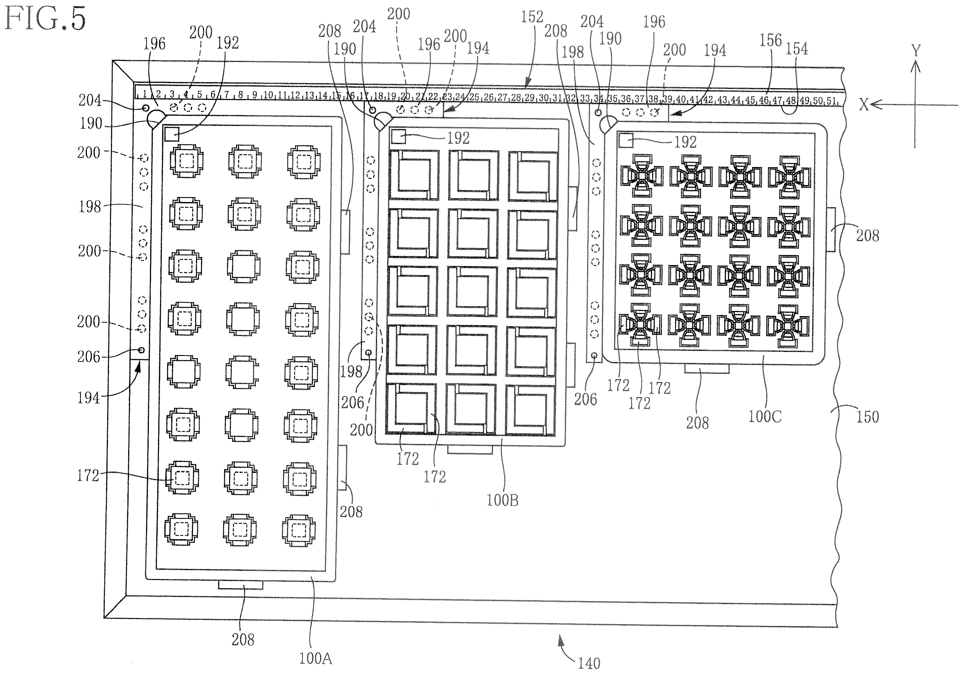

The support table 140 is constituted by a main body portion and a magnetic surface portion fixed to an upper face of the main body portion. The support table 140 has a horizontal support surface 150 constituted by the surface portion, and the trays 100 are placed and supported on the horizontal support surface 150. As illustrated in Fig. 5, the support surface 150 is provided with a guide bar 152 constituting a guide portion and extending parallel to the widthwise direction of the tray-type component supply device 10. The guide bar 152 has a positioning surface 154 that is perpendicular to the support surface 150. A scale 156 is provided on an upper face of the guide bar 152 which expands parallel to the support surface 150, and this scale 156 is provided along a longitudinal direction of the guide bar 152.

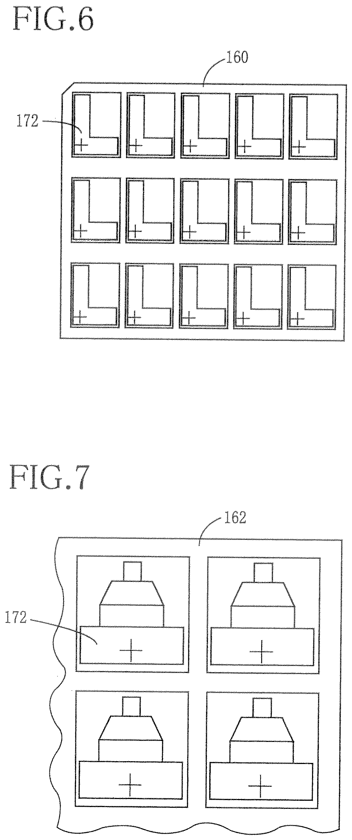

Each of the trays 100 is formed like a plate and has a rectangular or square shape in plan view. Each tray 100 has a plurality of unit spaces arranged in a grid pattern. The trays 100 include: a tray (hereinafter referred to as "single-component arranged tray") in which one electronic circuit component 172 (hereinafter abbreviated as "component 172") is disposed in each unit space 170 like a tray 100A illustrated on a left portion in Fig. 5; and a tray (hereinafter referred to as "multi-component arranged tray") in which a plurality of components 172 are arranged in each unit space 170 like a tray 100B and a tray 100C illustrated on central and right portions in Fig. 5, respectively. The single-component arranged tray 100A has a construction similar to that of a conventional tray, but each of the multi-component arranged trays 100B, 100C is a novel one. When compared with conventional trays 160, 162 illustrated in Figs. 6 and 7, respectively, it is apparent that a density of arrangement of the components 172 is considerably improved in the multi-component arranged trays 100B, 100C.

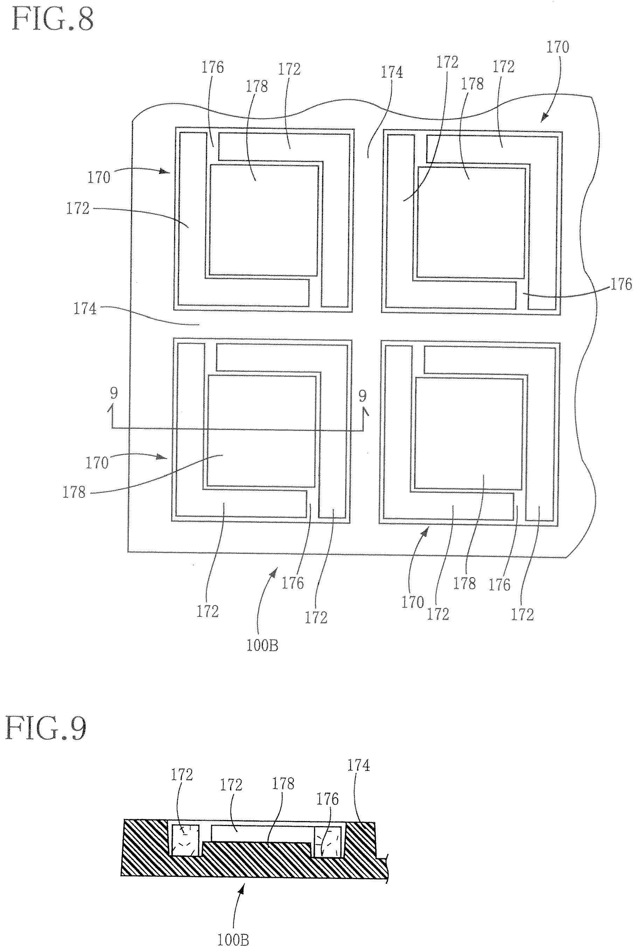

In the multi-component arranged trays 100B, 100C, each of the unit spaces 170 is surrounded by stiffening ribs 174, and Figs. 8 and 9 illustrate, by way of example, the unit spaces 170 of the multi-component arranged tray 100B among the unit spaces 170. In each unit space 170, a positioning protruding portion 178 is formed on a bottom face 176 that is surrounded by the stiffening ribs 174 and lower in height than the stiffening ribs 174. Two components 172 each having an L-shape in plan view are positioned by the positioning protruding portion 178 and the stiffening ribs 174 so as not to directly contact each other. If these two components 172 are held in direct contact with each other, when one of the components 172 is taken from the multi-component arranged tray 100B by suction of the vacuum nozzle 66, the other component 172 may be raised or moved onto the positioning protruding portion 178. However, the construction in the present embodiment can prevent these movements.

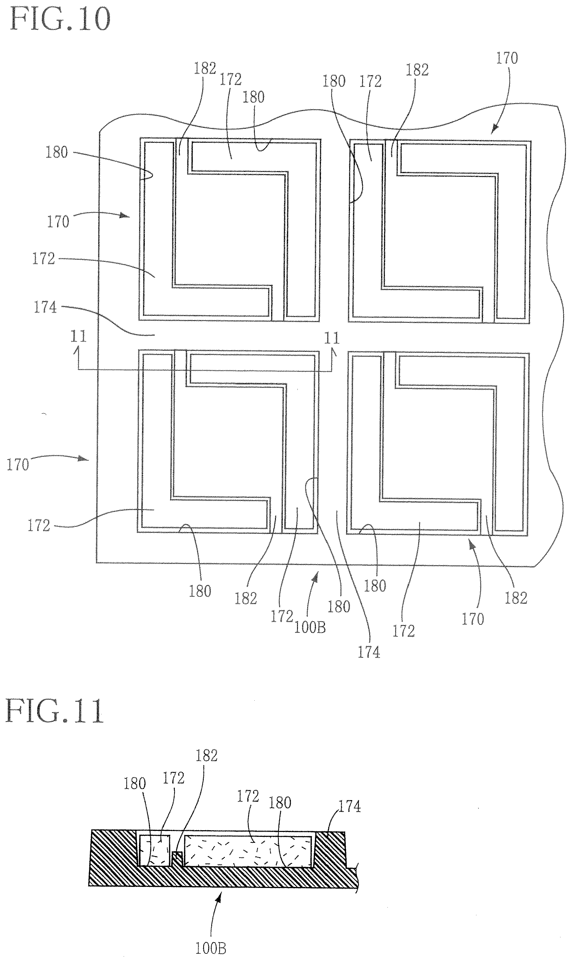

It is noted that a reason why the positioning protruding portion 178 is formed in the unit space 170 as described above is that this construction is convenient to prevent the L-shaped components 172 from contacting each other without a larger area of the unit space 170. As illustrated in Figs. 10 and 11, two positioning recessed portions 180 may be formed in the bottom face 176 of the unit space 170 such that lower portions of the L-shaped components 172 are respectively fitted in the positioning recessed portions 180, and this construction can also prevent direct contact of the components 172. In this case, however, a clearance is required between portions of the two components 172 which are the nearest to each other among them, and this clearance needs to have a size corresponding to the sum of: the thickness of a partition 182 for separating these portions from each other; and spaces located on opposite sides of the partition 182, so that a space required for the unit space 170 becomes larger by the thickness of the partition 182, and accordingly the density of arrangement of the components 172 lowers. In contrast, in the case where the one positioning protruding portion 178 is formed instead of the two positioning recessed portions 180, the partition 182 does not need to be formed, resulting in higher density of arrangement of the components 172.

However, a decision of which is better, the positioning protruding portion 178 or the positioning recessed portions 180, depends upon a material for forming the tray 100 and a method for forming the tray 100 and also depends upon a shape and arrangement of the component(s) 172 in the unit space 170. Thus, a user should determine which of the positioning protruding portion 178 and the positioning recessed portions 180 is to be formed, taking all these conditions into consideration. Also, the unit space 170 may be formed such that most of the positioning is performed by the positioning recessed portions, and a thin partition formed of a material different from that of the whole tray is provided between portions of the plurality of components which are the nearest to each other among them. In short, there needs to provide a positioning portion capable of positioning a plurality of components 172 arranged in the unit space 170 without direct contact of the components 172 with each other. In any construction, since the positioning recessed portion may be lower in height than the stiffening ribs 174, and the positioning protruding portion may also be lower than the stiffening ribs 174, the density of arrangement of the components 172 may be made higher also in these respects when compared with a case where the components 172 adjacent to each other is partitioned by the stiffening rib 174. This is because the tray 100 is typically manufactured by molding of a material composed mainly of synthetic resin, and a draft angle needs to be provided on a riser surface, and it is effective to provide an angle on the riser surface also in order to facilitate taking the component 172, but a higher riser surface leads to a larger bottom area of a wall portion forming the riser surface, and accordingly the density of arrangement of the components 172 is made low.

As illustrated in Fig. 5, each tray 100 (e.g., 100A, 100B, 100C) has three rounded corners of four corners, a non-rounded one of which has a cutout 190 so as to constitute a specific portion. The cutout 190 has a shape obtained by cutting a corner portion of the tray 100 in its thickness direction along a straight line intersecting two sides of the tray 100 which are perpendicular to each other. The tray 100 is provided with a two-dimensional code 192 which constitutes an information container. The two-dimensional code 192 contains information including: a tray identification code for identifying the tray 100 individually; the initial number of components accommodated (i.e., the number of unused components accommodated); a type or types of components; and permission or prohibition of ignoring designation of an initial taking start position in a state in which the tray 100 is not used (which will be described below). For example, this two-dimensional code 192 is provided on the tray 100 at a position adjacent to the cutout 190. Instead of the two-dimensional code, the information container may be a container, such as a bar code, that contains information in a form readable by a code reader, or an information storage that is accessible by communication for obtaining information, for example.

At least one tray 100 is supported on the support table 140 so as to be arranged in the X-axis direction in a state in which each tray 100 is positioned in the X-axis direction and the Y-axis direction by an L-shaped ruler 194 as a positioning member. The L-shaped ruler 194 includes a first ruler portion 196 and a second ruler portion 198 (each hereinafter abbreviated as "ruler portion") respectively extending in directions perpendicular to each other. A plurality of permanent magnets 200 are buried in the ruler portions 196, 198, specifically, the permanent magnets 200 are provided on bottom faces of the ruler portions 196, 198.

The L-shaped ruler 194 is removably secured to the support table 140 by a magnetic force. Thus, the L-shaped ruler 194 can be attached to any position on a magnetic support surface 150 of the support table 140. As illustrated in Fig. 5, the ruler portion 196 is held in close contact with the positioning surface 154 of the guide bar 152 and thereby positioned in the Y-axis direction, and the ruler portion 196 is attached to any position in the X-axis direction along the positioning surface 154. A first fiducial mark (hereinafter abbreviated as "fiducial mark") 204 is formed on a corner portion of the L-shaped ruler 194 at which the ruler portions 196, 198 intersect each other, and a second fiducial mark (hereinafter abbreviated as "fiducial mark") 206 is formed on a distal end portion of the ruler portion 198, which portion is farther from the corner portion at which the ruler portions 196, 198 intersect each other.

The type of the components 172 to be supplied by the tray-type component supply device 10, the type and arrangement of the tray(s) 100 to be supported by the support table 140, and a ruler installation position are input to a computer, which will be described below, by an operator with an input device 210 (see Fig. 12) and displayed on a display screen 214 of a display device 212, for example. The ruler installation position is a tray placement position and a tray support position and is commanded using a value of the scale 156 provided on the guide bar 152. The operator attaches the L-shaped ruler 194 to the command position. Data, e.g., representative of the ruler installation position is stored as tray support data into a tray support data memory provided in a RAM of the computer which will be described below.

After attaching the L-shaped ruler 194 to the support table 140, the operator places the tray(s) 100 on the support table 140. As illustrated in Fig. 5, two side faces of each tray 100 which extend perpendicular to each other are contacted with the respective ruler portions 196, 198 to position the tray 100, and in this state a restraining member 208 restrains the tray 100 to inhibit its movement. The rectangular tray 100 is principally placed such that its longitudinal direction (i.e., a long side) is parallel to the front and rear direction of the tray-type component supply device 10 (i.e., the Y-axis direction). Also, each tray 100 is determined to be placed in a state in which its two sides adjacent to the cutout 190 are held in contact with the respective ruler portions 196, 198, and the cutout 190 is located at a position corresponding to the corner portion at which the ruler portions 196, 198 intersect each other. Accordingly, the cutout 190 is provided in one of four corners of the tray 100, which one corner establishes the predetermined state of the L-shaped ruler 194. The restraining member 208 includes permanent magnets at least on at least a portion of a bottom face of the restraining member 208, and this restraining member 208 is secured to any position of the support surface 150 of the support table 140 by a magnetic force.

As illustrated in Fig. 12, the control device 16 is constituted mainly by a mounting control computer 260 including a CPU 250, a ROM 252, a RAM 254, and a bus 256 for connecting these components. Components connected to an input/output portion 262 include: an image processing computer 264 for processing image data obtained by, e.g., the input device 210 and the mark imaging device 82; and a database 266. The present database 266 is constituted mainly by a computer. Also, various actuators such as the X-axis moving motor 44 are connected to the input/output portion 262 via a drive circuit 270, and the display device 212 is connected to the input/output portion 262 via a control circuit 272. In this state, the display screen 214 of the display device 212 is controlled.

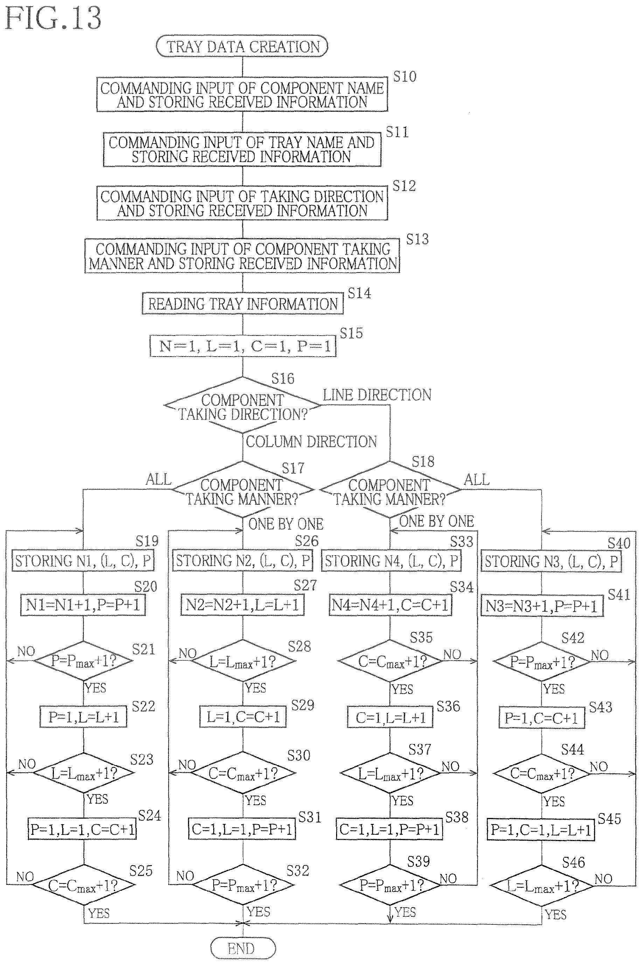

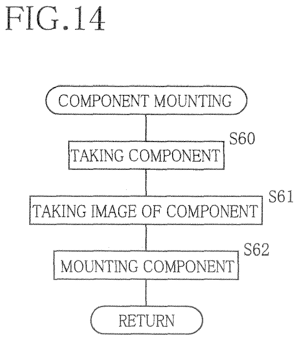

The ROM 252 stores various programs including: a tray-data creating program, illustrated in a flow chart in Fig. 13, for creating tray data for, e.g., the multi-component arranged trays 100B, 100C; a mounting program illustrated in a flow chart in Fig. 14; and a multi-component arrangement component-taking program for taking the components from the multi-component arranged trays 100B, 100C in the component taking step of the mounting program. The RAM 254 stores: data that is input or used during execution of the tray-data creating program which will be described below; and data that is input or used during execution of the multi-component arrangement component-taking program. The data input or used during execution of the tray-data creating program includes: a name of a component; a name of a tray; a direction of taking components; a taking manner; tray information (e.g., a position of the start space, the number of lines of the unit spaces, the number of columns of the unit spaces, pitches of the unit spaces, an order in which the components are taken from the unit space, positions of the components arranged in the unit space); and first-fourth taking data tables. The data input or used during execution of the multi-component arrangement component-taking program includes mounting data and an arrangement of the multi-component arranged trays. Also, the RAM 254 temporarily stores data that is required for the CPU 250 to execute various programs.

There will be next explained the tray-data creating program illustrated in Fig. 13 for creating the tray data for, e.g., the multi-component arranged trays 100B, 100C. It is noted that this tray-data creating program is executed to create tray data each specific to a corresponding one of combinations of types of components 172 and types of multi-component arranged tray 100. While the tray-data creating program is executed by the control device 16 of the electronic-circuit-component mounting system in the present embodiment, this program may be stored in a computer different from the control device 16 and executed.

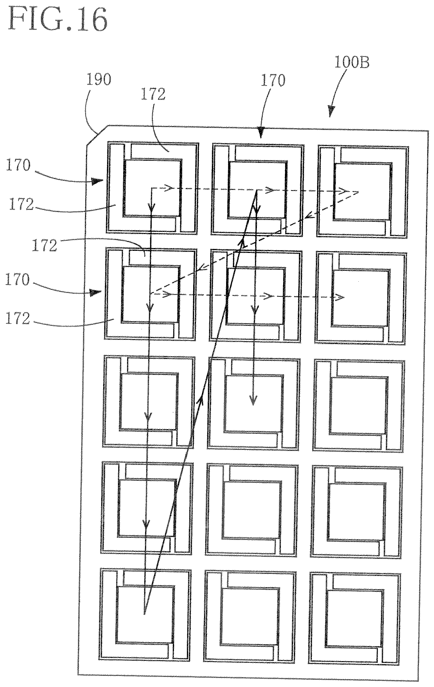

As illustrated in Fig. 16 taking the multi-component arranged tray 100B as an example, a manner of taking the components 172 from the multi-component arranged tray 100 includes: a taking manner in which the components 172 are sequentially taken from the unit spaces 170 in a column direction indicated by solid lines in the order from a unit space 170 nearest to the cutout 190 as a start space; and a taking manner in which the components 172 are sequentially taken from the unit spaces 170 in a line direction indicated by broken lines in the order from the start space, and one of these taking manners can be selected.

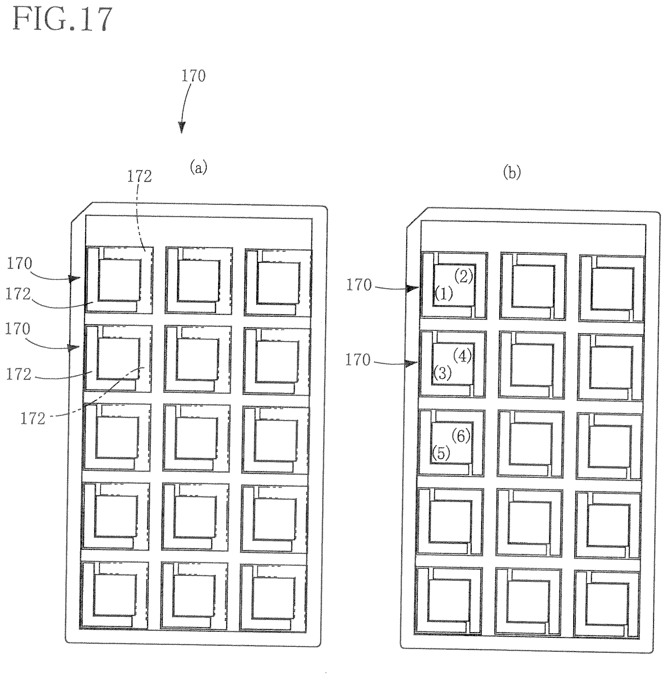

While a plurality of components 172 are arranged in each unit space 170, the manner of taking these components 172 includes one-component taking and all-component taking, one of which can be selected. In the one-component taking, the components are taken from the unit spaces one by one such that one component 172 is first taken from each unit space 170 (for example, one component 172 indicated by solid lines in Fig. 17(a) is taken from a start space 170, and then one component 172 indicated by solid lines is taken from the next unit space 170), and after one component 172 is taken from each of all the unit spaces 170, the other component 172 is taken from each unit space 170 (for example, the components 172 indicated by two-dot chain lines are taken in the order from the start space 170). In the all-component taking, the components are taken from the unit spaces one by one such that, as illustrated in (1), (2), (3), (4), and so on in Fig. 17(b), all the components 172 are taken from the start space 170, and then all the components 172 are taken from the next unit space 170. For each multi-component arranged tray, the order in which the components 172 are taken from each unit space 170 is determined in advance to one order.

The tray-data creating program begins with Step 10 (hereinafter abbreviated as "S10", and other steps are similarly abbreviated) at which a command for commanding the operator to input the name of the component is displayed on the display screen 214 of the display device 212, and when the name of the component is input from the input device 210, the name is stored into the RAM 254. At S11, input of the name of the tray is commanded, and the name is stored. At S12, selection of the taking direction, i.e., a direction in which the space 170 is changed, is commanded, and the selected taking direction is stored. At S13, selection of the component taking manner is commanded, and the selected component taking manner is stored.

At S14, the tray information is read. That is, information about the multi-component arranged tray 100 is read such as: the number of lines Lmax of the unit spaces 170 and the number of columns Cmax of the unit spaces 170; the position of the start space; pitches of the unit spaces 170 in the line direction and the column direction; and positions of a plurality of the components 172 (two components 172 in the case of the tray 100B) in each unit space 170. It is assumed that tray coordinates in the form of rectangular coordinates whose origin point is a vertex of the cutout 190 are defined for the multi-component arranged tray 100, and various kinds of information are defined by coordinate values of these tray coordinates. Examples of the information include: the position of the start space 170 (e.g., a position of the center of the unit space 170); positions in each unit space 170 at which components 172 are respectively sucked (i.e., the center of a portion of each component 172 which is to be sucked by the vacuum nozzle 66, and indicated by cross lines in Figs. 6 and 7); and the pitches of the unit spaces.

At S15, one ("1") is assigned to each of a taking number N representing the order number of a component taken from the multi-component arranged tray 100, a line number L and a column number C of the unit spaces 170, and an intra-space number P representing the order of components 172 taken from a unit space. That is, the first component 172 (N = 1) to be taken from the multi-component arranged tray 100 is set to a component 172 which is disposed in the start unit space (L = 1, C = 1) and whose intra-space number P is 1. In the present embodiment, there are four types of taking manners depending upon combination of whether the taking direction (i.e., the space change direction) selected at S12 is "LINE DIRECTION" or "COLUMN DIRECTION" illustrated in Fig. 16 and whether the component taking manner selected at S13 is "ONE BY ONE" illustrated in Fig. 17(a) or "ALL" illustrated in Fig. 17(b), and thus the taking number N is represented by "N1", "N2", "N3", and "N4" in order to distinguish the four types of taking manners.

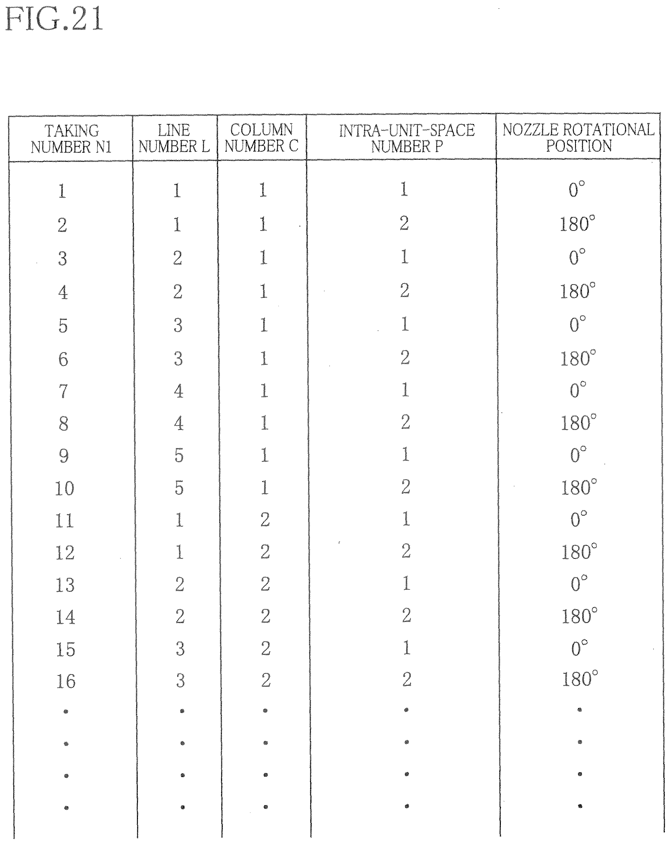

The taking direction is determined at S16, and the taking manner is determined at S17 and S18. When the taking direction and the taking manner are "COLUMN DIRECTION" and "ALL", respectively, the taking data is determined at S19-S25. At S19, the line number L and the column number C of the unit spaces 170 and the intra-unit-space number P are stored into the first taking data table of the RAM 254 illustrated in Fig. 21 in association with the taking number N1 at this point in time. At S20 and S21, the intra-unit-space number P is changed until the intra-unit-space number P becomes equal to the number of components 172 arranged in the unit space 170 (two in the case of the tray 100B). At S22 and S23, the line number L is changed until the line number L becomes equal to the number of lines Lmax. At S24 and S25, the column number C is changed until the column number C becomes equal to the number of columns Cmax. As a result, the first taking data table illustrated in Fig. 21 is finished. "NOZZLE ROTATIONAL POSITION" in Fig. 21 will be explained later.

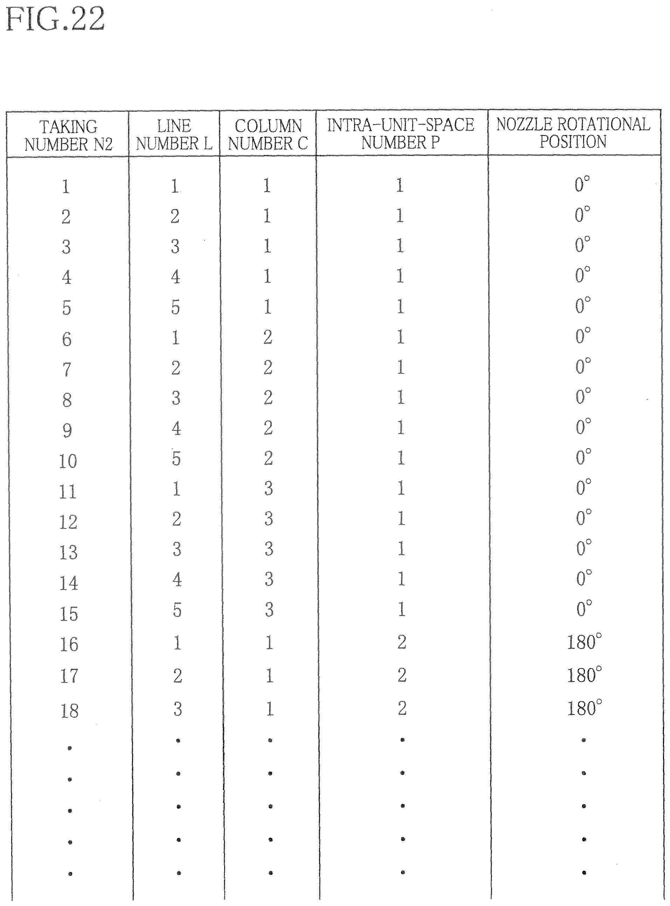

When the taking direction and the taking manner are "COLUMN DIRECTION" and "ONE BY ONE", respectively, the taking data is determined at S26-S32 in the same manner, and the second taking data table illustrated in Fig. 22 is finished. When the taking direction and the taking manner are "LINE DIRECTION" and "ALL", respectively, the third taking data table is finished. When the taking direction and the taking manner are "LINE DIRECTION" and "ONE BY ONE", respectively, the fourth taking data table is finished. The third taking data table is a table which is obtained by replacing the line number L and the column number C with each other in the first taking data table, and the fourth taking data table is a table which is obtained by replacing the line number L and the column number C with each other in the second taking data table, and illustration thereof is omitted.

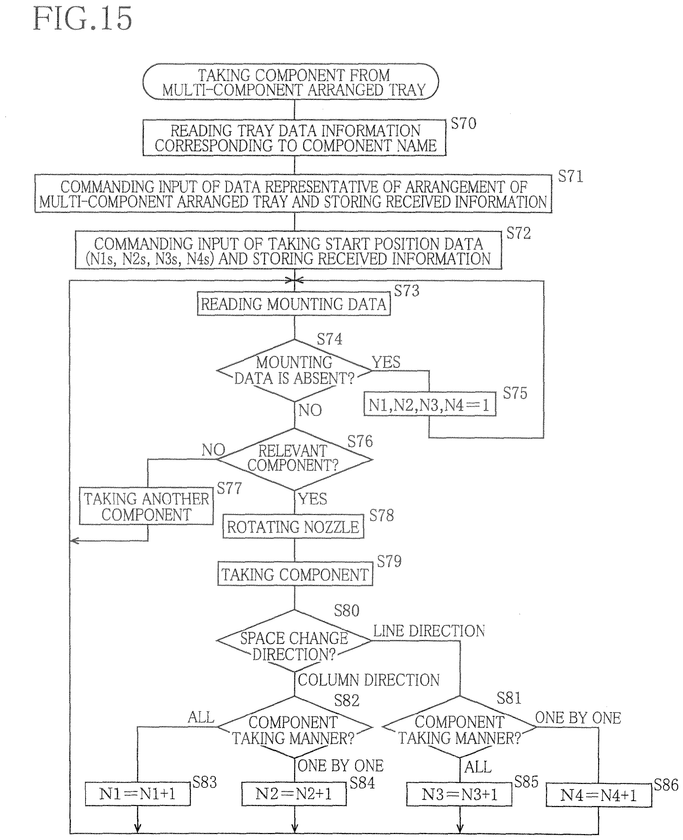

As illustrated in Fig. 14, the component 172 is mounted onto the circuit board 22 held by the board holding device 8 in the following manner. At S60, the component 172 is taken from the tray-type component supply device 10 or the feeder-type component supply device 12. At S61, the component imaging devices 90 take images of the component 172 held by the vacuum nozzle 66. At S62, the component 172 is mounted while correcting an error in position at which the vacuum nozzle 66 holds the component 172 and an error in position at which the board holding device 8 holds the circuit board 22. The imaging step at S61, the mounting step at S62, and taking the component at S61 from a common tray 100 in the feeder-type component supply device 12 and the tray-type component supply device are the same as those of conventional techniques, and an explanation thereof is omitted. There will be explained, with reference to the flow chart in Fig. 15, a novel operation of taking the component 172 from the multi-component arranged trays 100.

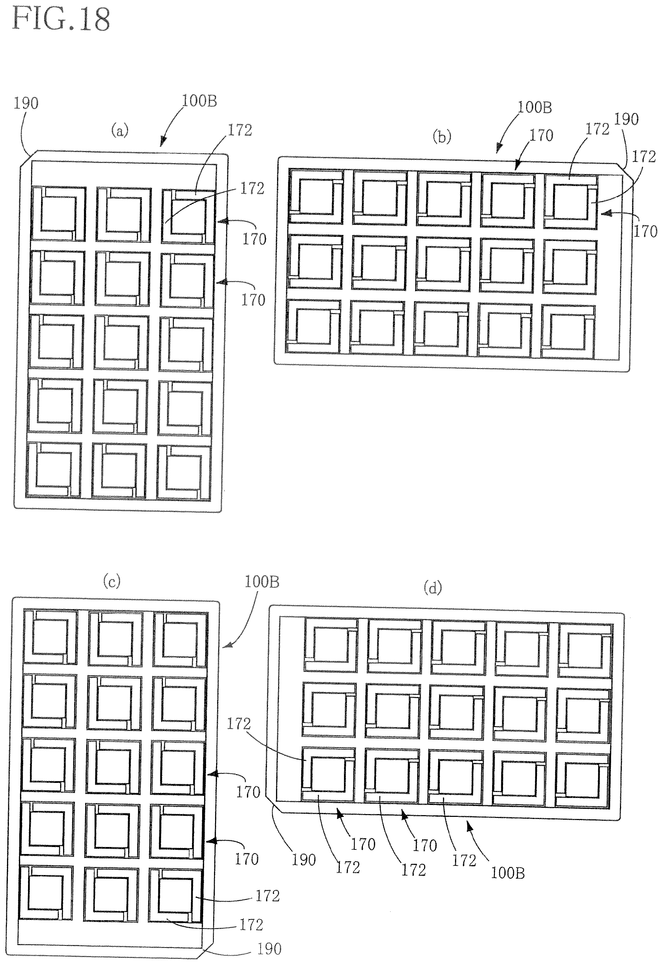

S70-S72 in Fig. 15 are steps executed before a start of the mounting of the component 172. At S70, an input of the component 172 and the tray information of the multi-component arranged tray 100 accommodating the component (the tray information created by the tray-data creating program in Fig. 13) are commanded, and information received is stored into the RAM 254. This input and storage are executed for all the multi-component arranged trays 100 to be mounted on each of the electronic-circuit-component mounting machine 18. At S71, an input of data representing the orientation of the multi-component arranged tray 100 is commanded. The multi-component arranged tray 100 is planned to be disposed on the support table 140 in one of four types of rotation orientation, namely, a normal orientation illustrated in Fig. 18(a), a 90 degree rotated orientation illustrated in Fig. 18(b), a 180 degree rotated orientation illustrated in Fig. 18(c), and a -90 degree rotated orientation illustrated in Fig. 18(d). This is to minimize an angle of rotation of the component 172 about a nozzle axis which is performed by the time when the component 172 accommodated in the multi-component arranged tray 100 is taken by the vacuum nozzle and mounted on the circuit board 22, for example. Also, since the tray 100 is placed on one of various positions of the support table 140 as described above, an input of data representative of the position and the rotation orientation is commanded at S71, and this input is also performed for all the multi-component arranged trays 100 to be mounted on each of the electronic-circuit-component mounting machine 18.

At S72, an input of taking start position data is commanded. In a case where the multi-component arranged tray 100 disposed on the support table 140 is not used at all, the taking start position has been determined as described above at a position where the unit space is located at the first line and the first column (L = 1, C = 1), and the intra-unit-space number is one (P = 1). In a case where some of the components have already used, however, the operator needs to designate a taking number N representing the order number of a component taken from the entire multi-component arranged tray 100. In addition, since there are four different positions as the actual taking start position, depending upon the combination of whether the taking direction is "LINE DIRECTION" or "COLUMN DIRECTION" and whether the component taking manner is "ONE BY ONE" or "ALL", the operator needs to designate taking start numbers (N1s, N2s, N3s, N4s) respectively as the taking numbers (N1, N2, N3, N4) in the four types of taking manners, and an input is performed at S72 and stored into the RAM 254. These input and storage are also performed for all the multi-component arranged trays 100 to be mounted on each of the electronic-circuit-component mounting machine 18.

After the above-described initial settings, the component mounting is started, and the mounting data is read at S73. At S74, it is determined whether there is mounting data to be read or not, that is, it is determined whether all the components 172 to be mounted in the electronic-circuit-component mounting machine 18 have been mounted or not. When the mounting on one circuit board 22 is finished, a positive decision (YES) is made, and this flow goes to S75. At S75, the taking number N (N1, N2, N3, N4) is reset to one, and this flow returns to S73. When a negative decision (NO) is made at S74, on the other hand, this flow goes to S76. The mounting data read at S73 contains, as in the conventional technique, information about a type of the component 172 to be taken, a position on the circuit board at which the component is to be mounted, and a rotation orientation of the component. Based on this information, it is determined at S76 whether the component 172 to be taken next is a relevant component or not, that is, it is determined whether or not the component 172 to be taken next is a component accommodated in any of the multi-component arranged trays 100 mounted on the electronic-circuit-component mounting machine 18. When a negative decision (NO) is made at S76, another component is taken at S77, that is, a component is taken from a normal tray 100 on which only one component 172 is accommodated in each space, or a component is taken from the feeder-type component supply device 12.

When a positive decision (YES) is made at S76, on the other hand, the vacuum nozzle 66 is rotated at S78. A rotation orientation of the component 172 to be taken next in the multi-component arranged tray 100 is determined based on information stored at S70-S72, and a rotation orientation of the component 172 at mounting is determined based on the mounting data read at S73. If the vacuum nozzle 66 is rotated after an image of the component is taken at S61 of the mounting program, the component 172 may deviate from the vacuum nozzle 66 due to an inertial force. The rotation orientation of the component 172 is preferably adjusted to a rotation orientation as near the rotation orientation at the mounting as possible by the time of the imaging after the component 172 is taken. In addition, the vacuum nozzle 66 is preferably located at a rotational position as near the origin point as possible at the imaging in order to eliminate effect of a bend in the vacuum nozzle. Accordingly, before the component 172 is taken, the vacuum nozzle 66 is rotated in advance at S78 to a rotational position that satisfies the above-described conditions. The nozzle rotational position in Figs. 21 and 22 represents the above-described rotational position. It is noted that, as apparent from Figs. 21 and 22 in which there is a case where the nozzle rotational position is 0°, there is, of course, a case where the vacuum nozzle 66 does not need to be rotated at S78, and as described with reference to Fig. 18 the rotation orientation of the multi-component arranged tray 100 is selected taking this into consideration.

At S79, the component 172 is taken. Specifically, the component 172 is of course taken from a multi-component arranged tray 100 that accommodates components 172 of a type represented by the mounting data, among the multi-component arranged trays 100 mounted on the electronic-circuit-component mounting machine 18.

It is noted that the tray data created by the execution of the tray-data creating program in Fig. 13 contains the line number L and the column number C of the unit spaces 170 and the intra-space number P in the unit space. While each of these numbers is for identifying a component taking position in the multi-component arranged tray 100, absolute positional coordinates in the electronic-circuit-component mounting machine 18 need to be identified to actually cause the vacuum nozzle 66 to take the component 172. To do this, each of the numbers L, C, P needs to be converted, based on the tray information stored in the RAM 254 at S14, into a coordinate value in tray coordinates whose origin point is a vertex of a triangle defining the cutout 190, and the coordinate value in the tray coordinates needs to be converted into a coordinate value of absolute coordinates in the electronic-circuit-component mounting machine 18, based on the data representing the orientation of the multi-component arranged tray 100 which is input at S71. In the present embodiment, these calculations are executed at S79 each time when a component is taken, but this is not essential, and the conversions only need to be executed at any timings after the determination of the numbers L, C, P in the tray-data creating program and before the start of the component taking operation at S79. For example, in the tray-data creating program illustrated in Fig. 13, each of the numbers L, C, P is converted into the coordinate value in the tray coordinates after the determination of the numbers L, C, P, and the coordinate value in the tray coordinates is converted into the coordinate value of the absolute coordinates in the electronic-circuit-component mounting machine 18 during changeover performed before the start of the component mounting program in Fig. 14.

After the component 172 is taken at S79, the component taking direction and the component taking manner are determined at S80, S81, and S82 for tray data relating to the multi-component arranged tray 100 from which the component is taken. Based on this determination, one of processings at S83-S86 is executed, so that one of the taking numbers N1, N2, N3, N4 is updated based on a combination of the component taking direction and the component taking manner. As a result, taking one component 172 from the multi-component arranged tray 100 is finished, and this flow of the multi-component arrangement component-taking program returns to S73. However, the next mounting data is read after the processing at S62 of the component mounting program is finished.

In the present embodiment, the plurality of unit spaces 170 are defined by the line number and the column number and arranged in a grid pattern at predetermined pitches in the line direction and the column direction, and a rule according to which these unit spaces 170 are arranged is a first rule. Also, the components 172 are arranged in the same pattern in each of the unit spaces 170, and a rule according to which this pattern is defined is a second rule. Each of the multi-component arranged trays 100B, 100C is one example of a surface holder.

While the embodiment of the present invention has been described in detail above, it is to be understood that the invention is not limited to the details of the illustrated embodiment, but may be embodied with various changes and modifications such as forms described in "FORMS OF THE INVENTION", which may occur to those skilled in the art, without departing from the spirit and scope of the invention.

For example, a taking start position of a new multi-component arranged tray 100 is uniquely determined at a unit space 170 nearest to the cutout 190 in the above-described embodiment but may be determined at a unit space 170 nearest to any of the corners on which the cutout 190 is not formed.

In the above-described embodiment, in the case where the components are taken in the component taking manner in which one component 172 is sequentially taken from each unit space 170 of the multi-component arranged trays 100B, 100C, one component 172 is taken from each of all the unit spaces 170 of one tray 100, and then another component 172 is started to be taken from each of all the unit spaces 170 of one multi-component arranged tray 100. Accordingly, assuming that each group of the components 172 having the same intra-space number P is constituted by components accommodated in one conventional tray (for example, assuming that the multi-component arranged tray 100B is constituted by two different conventional trays 2 and that the multi-component arranged tray 100C is constituted by four different conventional trays), the components can be taken from the multi-component arranged tray using the same component mounting program as used for taking components from a conventional tray.

Even in the case where all the components 172 are taken from the unit space 170, and then a plurality of components 172 are taken from the next unit space 170, the components can be taken from the multi-component arranged tray using the same component mounting program as used for taking components from a conventional tray, by considering that components are taken one by one from different conventional trays alternately.

In the above-described embodiment, in the case where the components are taken in the component taking manner in which one component 172 is sequentially taken from each unit space 170 of the multi-component arranged trays 100B, 100C, one component 172 is taken from each of all the unit spaces of one tray 100, and then another component 172 is started to be taken from each of all the unit spaces of one tray 100. Thus, in a case where a partly-used multi-component arranged tray 100B, 100C from which some of the components 172 have been taken is used, if components are not taken in the same manner as a component taking manner that is used when the components are partly taken from the multi-component arranged tray 100B, 100C, creation of the tray data becomes cumbersome. In contrast, in a case where a predetermined number of unit spaces 170 (e.g., unit spaces in one line or one column) are taken as one group, and after one of the components 172 has been taken from each of all the unit spaces 170 of one group, another of the components 172 is taken from each of the unit spaces 170 of the one group in the order from a first unit space, it is possible to determine whether the components 172 are partly used or not, with the predetermined number of spaces as a unit, allowing simplification of data processing that is executed when a partly-used multi-component arranged tray 100 is used.

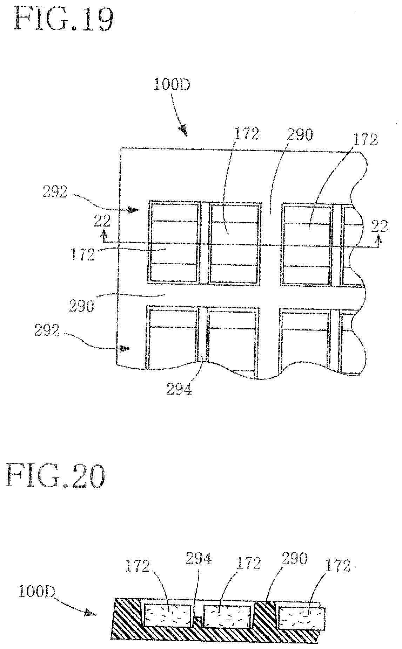

Also, in many cases in the multi-component arranged trays 100B, 100C, a plurality of components 172 arranged in the unit space 170 respectively have different rotation orientations (i.e., rotational positions), resulting in effective density of arrangement of the components 172 in particular, but such different rotation orientations are not essential. For example, a multi-component arranged tray 100D illustrated in Figs. 19 and 20 has unit spaces 292 arranged in a grid pattern and each enclosed by stiffening ribs 290, and each of the unit spaces 292 accommodates two components 172 arranged in the same rotation orientation. As illustrated in Fig. 20, formed between these two components 172 is only a positioning protruding portion 294 which has a low and narrow shape when compared with the stiffening rib 290, resulting in a smaller space required between the two components 172 in the unit space 292 when compared with a space between two components 172 adjacent to each other and located on opposite sides of the stiffening rib 290. That is, though not all the components 172 are arranged according to the same rule, the plurality of unit spaces 292 are arranged according to the same rule (i.e., the first rule), and in each of the plurality of unit spaces 292, a plurality of the components 172 (two in the illustrated example) are arranged in the same state (noted that a rule for defining this state is the second rule), so that the components 172 can be taken in the same manner as in the above-described embodiment. The density of arrangement of the components 172 can be made higher by an amount by which a space between the plurality of components 172 arranged in the unit space 292 can be made smaller. The electronic-circuit-component mounting system illustrated in Figs. 19 and 20 configured to take the component 172 from the multi-component arranged tray 100D and mount the component 172 onto the circuit board is also one embodiment of the claimable invention.

### DESCRIPTION OF REFERENCE NUMERALS

6: Board Conveyor Device, 8: Board Holding Device, 10: Tray-type Component Supply Device, 12: Feeder-type Component Supply Device, 14: Mounting Device, 16: Control Device, 18: Electronic-circuit-component Mounting Machine, 30: Head Unit, 32: Head Moving Device, 52: Y-axis Slide, 60: Head Holding Device, 62: Mounting Head, 64: Nozzle Holder, 66: Vacuum Nozzle, 68: Head Elevating and Lowering Device, 70: Head Rotating Device, 90: Component Imaging Device, 100: Tray (100a: Single-component Arranged Tray, 100b, 100c, 100d: Multi-component Arranged Tray), 140: Tray Support Table (Support Table), 150: Support Surface, 152: Guide Bar, 154: Positioning Surface, 156: Scale, 170: Unit Space, 172: Electronic Circuit Component (Component), 174: Stiffening Rib, 176: Bottom Face, 178: Positioning Protruding Portion, 180: Positioning Recessed Portion, 182: Partition, 190: Cutout, 210: Input Device, 212: Display Device, 214: Display Screen, 260: Mounting Control Computer, 292: Unit Space, 294: Positioning Protruding Portion

## Claims

1. An electronic-circuit-component mounting system, comprising:
a component holder support device (140) configured to support a component holder (100) which comprises a plurality of unit spaces (170; 292) defined according to repetition of a first rule and which holds a plurality of electronic circuit components (172) in each of the plurality of unit spaces (170; 292), each of the unit spaces being configured as component accommodation recessed portion (180) and/or
being configured to hold a plurality of components having different rotation orientations, the electronic circuit components (172) being arranged in the same pattern in each of the unit spaces (170; 292), this pattern being defined according to a second rule;
a circuit substrate support device (8) configured to support a circuit substrate (22) on which an electronic circuit component is to be mounted;
a component holding member (66) configured to releasably hold the electronic circuit component;
a component holding position obtainer configured to sequentially obtain a plurality of component holding positions each of which is a component holding position at which the component holding member (66) is to hold a corresponding one of the plurality of electronic circuit components held in the plurality of unit spaces (170; 292) of the component holder (100) supported by the component holder support device (140);
a component mounting position obtainer configured to sequentially obtain a plurality of component mounting positions each of which is a component mounting position at which a corresponding one of the plurality of electronic circuit components is to be mounted on the circuit substrate (22) supported by the circuit substrate support device (8); and
a relatively moving device configured to move the component holder support device (140) and the circuit substrate support device (8), and the component holding member (66) relatively to each other based on the component holding position obtained by the component holding position obtainer and the component mounting position obtained by the component mounting position obtainer, and thereafter control the component holding member (66) to take the electronic circuit component from the component holder (100) supported by the component holder support device (140), hold the electronic circuit component, and mount the electronic circuit component onto the circuit substrate (22) supported by the circuit substrate support device (8).

2. The electronic-circuit-component mounting system according to claim 1, wherein the component holding position obtainer is configured to further obtain a rotational position of the component holding member (66) at a time when the electronic circuit component is taken from the component holder (100).

3. The electronic-circuit-component mounting system according to claim 1 or 2, wherein the component holder support device (140) comprises a surface holder support device (140) configured to support a surface holder (100B, 100C; 100D) as the component holder (100) which comprises the plurality of unit spaces (170; 292) arranged according to a rule defined repeatedly in two directions which intersect each other on one surface of the surface holder (100B, 100C; 100D).

4. The electronic-circuit-component mounting system according to claim 3, wherein an order of the plurality of unit spaces (170; 292) is determined in advance, wherein a processing is repeatedly executed for the plurality of unit spaces (170; 292) in the order of the plurality of unit spaces (170; 292), wherein, in the processing, the relatively moving device causes the component holding member (66) to hold one by one a plurality of electronic circuit components held by an earlier unit space to which an earlier order number is assigned among the plurality of unit spaces (170; 292), and after all of the plurality of electronic circuit components held by the earlier unit space are held, the relatively moving device causes the component holding member (66) to hold one by one all of a plurality of electronic circuit components held by a later unit space in an order identical with an order in which the component holding member (66) holds the plurality of electronic circuit components held by the earlier unit space, and wherein the later unit space is a space to which an order number that follows the order number of the earlier unit space is assigned.

5. The electronic-circuit-component mounting system according to claim 3, wherein an order of the plurality of unit spaces (170; 292) is determined in advance, wherein a processing is repeatedly executed for the plurality of unit spaces (170; 292) in the order of the plurality of unit spaces (170; 292), and wherein, in the processing, the relatively moving device causes the component holding member (66) to hold one electronic circuit component held in a first state of the plurality of states in an earlier unit space to which an earlier order number is assigned among the plurality of unit spaces (170; 292), and next the relatively moving device causes the component holding member (66) to hold an electronic circuit component held in the first state in a later unit space to which an order number that follows the order number of the earlier unit space is assigned.

## Patentansprüche

1. Montagesystem für elektronische Schaltungskomponenten, das umfasst:
eine Komponentenhalter-Lagerungsvorrichtung (140), die konfiguriert ist, um einen Komponentenhalter (100) zu lagern, der eine Vielzahl von entsprechend der Wiederholung einer ersten Regel definierten Raumeinheiten (170; 292) umfasst, und der eine Vielzahl von elektronischen Schaltungskomponenten (172) in jeder aus der Vielzahl von Raumeinheiten (170; 292) hält, wobei jede der Raumeinheiten (170; 292) als ausgespartes Komponentenaufnahmeteil (180) konfiguriert ist und/oder konfiguriert ist, um eine Vielzahl von Komponenten mit unterschiedlichen Rotationsausrichtungen zu halten, wobei die elektronischen Schaltungskomponenten (172) in dem gleichen Muster in jeder der Raumeinheiten (170; 292) angeordnet sind, wobei dieses Muster entsprechend einer zweiten Regel definiert ist;
eine Schaltungssubstrat-Lagerungsvorrichtung (8), die konfiguriert ist, um ein Schaltungssubstrat (22) zu lagern, auf dem eine elektronische Schaltungskomponente zu montieren ist;
ein Komponentenhalteelement (66), das konfiguriert ist, um die elektronische Schaltungskomponente lösbar zu halten;
eine Komponentenhaltepositions-Beziehungseinrichtung, die konfiguriert ist, um nacheinander eine Vielzahl von Komponentenhaltepositionen zu beziehen, von denen jede eine Komponentenhalteposition ist, an der das Komponentenhalteelement (66) eine entsprechende aus der Vielzahl von elektronischen Schaltungskomponenten halten soll, die in der Vielzahl von Raumeinheiten (170; 292) des von der Komponentenhalter-Lagerungsvorrichtung (140) gelagerten Komponentenhalters (100) gehalten werden;
eine Komponentenmontagepositions-Beziehungseinrichtung, die konfiguriert ist, um nacheinander eine Vielzahl von Komponentenmontagepositionen zu beziehen, von denen jede eine Komponentenmontageposition ist, an der eine entsprechende aus der Vielzahl von elektronischen Schaltungskomponenten auf dem von der Schaltungssubstrat-Lagerungsvorrichtung (8) gelagerten Schaltungssubstrat (22) zu montieren ist; und
eine relativ bewegliche Vorrichtung, die konfiguriert ist, um die Komponentenhalter-Lagerungsvorrichtung (140) und die Schaltungssubstrat-Lagerungsvorrichtung (8) und das Komponentenhalteelement (66) auf der Basis der Komponentenhalteposition, die durch die Komponentenhaltepositions-Beziehungseinrichtung bezogen wird, und der Komponentenmontageposition, die durch die Komponentenmontagepositions-Beziehungseinrichtung bezogen wird, relativ zueinander zu bewegen und danach das Komponentenhalteelement (66) zu steuern, um die elektronische Schaltungskomponente von dem von der Komponentenhalter-Lagerungsvorrichtung (140) gelagerten Komponentenhalter (100) zu entnehmen, die elektronische Schaltungskomponente zu halten und die elektronische Schaltungskomponente auf dem durch die Schaltungssubstrat-Lagerungsvorrichtung (8) gelagerten Schaltungssubstrat (22) zu montieren.

2. Montagesystem für elektronische Schaltungskomponenten nach Anspruch 1, wobei die Komponentenhaltepositions-Beziehungseinrichtung konfiguriert ist, um des Weiteren eine Rotationsposition des Komponentenhalteelements (66) zu einer Zeit zu beziehen, wenn die elektronische Schaltungskomponente von dem Komponentenhalter (100) entnommen wird.

3. Montagesystem für elektronische Schaltungskomponenten nach Anspruch 1 oder 2, wobei die Komponentenhalter-Lagerungsvorrichtung (140) eine Oberflächenhalter-Lagerungsvorrichtung (140) umfasst, die konfiguriert ist, um einen Oberflächenhalter (100B, 100C, 100D) als den Komponentenhalter zu lagern, der die Vielzahl von Raumeinheiten (170; 292) umfasst, die entsprechend einer Regel angeordnet sind, die wiederholt in zwei Richtungen definiert ist, die einander auf einer Oberfläche des Oberflächenhalters (100B, 100C, 100D) schneiden.

4. Montagesystem für elektronische Schaltungskomponenten nach Anspruch 3, wobei eine Reihenfolge der Vielzahl von Raumeinheiten (170; 292) im Voraus bestimmt wird, wobei eine Verarbeitung für die Vielzahl von Raumeinheiten (170; 292) in der Reihenfolge der Vielzahl von Raumeinheiten (170; 292) wiederholt ausgeführt wird, wobei bei der Verarbeitung die relativ bewegliche Vorrichtung bewirkt, dass das Komponentenhalteelement (66) einzeln eine Vielzahl von elektronischen Schaltungskomponenten hält, die von einer früheren Raumeinheit, der eine frühere Reihenfolgenummer zugewiesen ist, unter der Vielzahl von Raumeinheiten (170; 292) gehalten wurde, und nachdem alle aus der Vielzahl von elektronischen Schaltungskomponenten, die durch die frühere Raumeinheit gehalten wurden, gehalten werden, die relativ bewegliche Vorrichtung bewirkt, dass das Komponentenhalteelement (66) einzeln alle aus einer Vielzahl von elektronischen Schaltungskomponenten hält, die von einer späteren Raumeinheit in einer Reihenfolge gehalten werden, die mit einer Reihenfolge identisch ist, in der das Komponentenhalteelement (66) die Vielzahl von elektronischen Schaltungskomponenten hält, die von der früheren Raumeinheit gehalten wurden, und wobei die spätere Raumeinheit ein Raum ist, dem eine Reihenfolgenummer zugewiesen wird, die der Reihenfolgenummer der früheren Raumeinheit folgt.

5. Montagesystem für elektronische Schaltungskomponenten nach Anspruch 3, wobei eine Reihenfolge der Vielzahl von Raumeinheiten (170; 292) im Voraus bestimmt wird, wobei eine Verarbeitung für die Vielzahl von Raumeinheiten (170; 292) in der Reihenfolge der Vielzahl von Raumeinheiten (170; 292) wiederholt ausgeführt wird und wobei bei der Verarbeitung die relativ bewegliche Vorrichtung bewirkt, dass das Komponentenhalteelement (66) eine elektronische Schaltungskomponente hält, die in einem ersten Zustand aus der Vielzahl von Zuständen in einer früheren Raumeinheit, der eine frühere Reihenfolgenummer zugewiesen ist, unter der Vielzahl von Raumeinheiten gehalten wurde, und als nächstes die relativ bewegliche Vorrichtung bewirkt, dass das Komponentenhalteelement (66) eine elektronische Schaltungskomponente hält, die in dem ersten Zustand in einer späteren Raumeinheit gehalten wird, der eine Reihenfolgenummer zugewiesen ist, die der Reihenfolgenummer der früheren Raumeinheit folgt.

## Revendications

1. Système de montage de composants de circuit électronique, comprenant :
un dispositif de support de dispositif de maintien de composants (140) configuré pour supporter un dispositif de maintien de composants (100) qui comprend une pluralité d'espaces unitaires (170 ; 292) définis conformément à une répétition d'une première règle et qui maintient une pluralité de composants de circuit électronique (172) dans chacun de la pluralité d'espaces unitaires (170 ; 292), chacun des espaces unitaires étant configuré sous forme d'une partie évidée de logement de composants (180) et/ou étant configuré pour maintenir une pluralité de composants ayant différentes orientations de rotation, les composants de circuit électronique (172) étant agencés selon le même motif dans chacun des espaces unitaires (170 ; 292), ce motif étant défini conformément à une seconde règle ;
un dispositif de support de substrat de circuit (8) configuré pour supporter un substrat de circuit (22) sur lequel un composant de circuit électronique doit être monté ;
un élément de maintien de composant (66) configuré pour maintenir de manière libérable le composant de circuit électronique ;
un dispositif d'obtention de positions de maintien de composant configuré pour obtenir séquentiellement une pluralité de positions de maintien de composant dont chacune est une position de maintien de composant à laquelle l'élément de maintien de composant (66) doit maintenir un composant correspondant de la pluralité de composants de circuit électronique maintenus dans la pluralité d'espaces unitaires (170 ; 292) du dispositif de maintien de composants (100) supporté par le dispositif de support de dispositif de maintien de composants (140) ;
une dispositif d'obtention de positions de montage de composant configuré pour obtenir séquentiellement une pluralité de positions de montage de composant dont chacune est une position de montage de composant à laquelle un composant correspondant de la pluralité de composants de circuit électronique doit être monté sur le substrat de circuit (22) supporté par le dispositif de support de substrat de circuit (8) ; et
un dispositif de déplacement relatif configuré pour déplacer le dispositif de support de dispositif de maintien de composants (140) et le dispositif de support de substrat de circuit (8), et l'élément de maintien de composant (66) les uns par rapport aux autres sur la base de la position de maintien de composant obtenue par le dispositif d'obtention de positions de maintien de composant et de la position de montage de composant obtenue par le dispositif d'obtention de positions de montage de composant, et ensuite pour commander l'élément de maintien de composant (66) pour prendre le composant de circuit électronique depuis le dispositif de maintien de composants (100) supporté par le dispositif de support de dispositif de maintien de composants (140), maintenir le composant de circuit électronique, et monter le composant de circuit électronique sur le substrat de circuit (22) supporté par le dispositif de support de substrat de circuit (8).

2. Système de montage de composants de circuit électronique selon la revendication 1, dans lequel le dispositif d'obtention de positions de maintien de composant est configuré pour obtenir en outre une position de rotation de l'élément de maintien de composant (66) à un moment où le composant de circuit électronique est extrait du dispositif de maintien de composants (100).

3. Système de montage de composants de circuit électronique selon la revendication 1 ou 2, dans lequel le dispositif de support de dispositif de maintien de composants (140) comprend un dispositif de support de dispositif de maintien de surface (140) configuré pour supporter un dispositif de maintien de surface (100B, 100C ; 100D) en tant que dispositif de maintien de composants (100) qui comprend la pluralité d'espaces unitaires (170 ; 292) agencés conformément à une règle définie de façon répétée dans deux directions qui se croisent l'une l'autre sur une surface du dispositif de maintien de surface (100B, 100C ; 100D).

4. Système de montage de composants de circuit électronique selon la revendication 3, dans lequel un ordre de la pluralité d'espaces unitaires (170 ; 292) est déterminé à l'avance, dans lequel un traitement est exécuté de façon répétée pour la pluralité d'espaces unitaires (170 ; 292) dans l'ordre de la pluralité d'espaces unitaires (170 ; 292), dans lequel, lors du traitement, le dispositif de déplacement relatif amène l'élément de maintien de composant (66) à maintenir un par un une pluralité de composants de circuit électronique maintenus par un espace unitaire antérieure dans lequel un numéro d'ordre antérieur est attribué parmi la pluralité d'espaces unitaires (170 ; 292), et après que la totalité de la pluralité de composants de circuit électronique maintenus par l'espace unitaire antérieur sont maintenus, le dispositif de déplacement relatif amène l'élément de maintien de composant (66) à maintenir un par un la totalité d'une pluralité de composants de circuit électronique maintenus par un espace unitaire ultérieur dans un ordre identique à un ordre dans lequel l'élément de maintien de composant (66) maintien la pluralité de composants de circuit électronique maintenus par l'espace unitaire antérieur, et dans lequel l'espace unitaire ultérieur est un espace auquel un numéro d'ordre qui suit le numéro d'ordre de l'espace unitaire antérieur est attribué.

5. Système de montage de composants de circuit électronique selon la revendication 3, dans lequel un ordre de la pluralité d'espaces unitaires (170 ; 292) est déterminé à l'avance, dans lequel un traitement est exécuté de manière répétée pour la pluralité d'espaces unitaires (170 ; 292) dans l'ordre de la pluralité d'espaces unitaires (170 ; 292), et dans lequel, lors du traitement, le dispositif de déplacement relatif amène l'élément de maintien de composant (66) à maintenir un composant de circuit électronique maintenu dans un premier état de la pluralité d'états dans un espace unitaire antérieur auquel un numéro d'ordre antérieur est attribué parmi la pluralité d'espaces unitaires (170 ; 292), et ensuite le dispositif de déplacement relatif amène l'élément de maintien de composant (66) à maintenir un composant de circuit électronique maintenu dans le premier état dans un espace unitaire ultérieur auquel un numéro d'ordre qui suit le numéro d'ordre de l'espace unitaire antérieur est attribué.
